# EUROPEAN PATENT SPECIFICATION

(11) **EP 3 684 887 B1**
(45) Date of publication and mention of the grant of the patent: **25.09.2024**
(21) Application number: 18860670.1
(22) Date of filing: 28.09.2018
(51) Int. Cl.: H01L 21/306, H01L 29/66, H01L 29/775, H01L 29/786, C09K 13/00

(54) **ETCHING SOLUTION FOR SIMULTANEOUSLY REMOVING SILICON AND SILICON-GERMANIUM ALLOY FROM A SILICON-GERMANIUM/SILICON STACK DURING MANUFACTURE OF A SEMICONDUCTOR DEVICE**
ÄTZLÖSUNG ZUR GLEICHZEITIGEN ENTFERNUNG VON SILICIUM UND SILICIUM-GERMANIUM-LEGIERUNG AUS EINEM SILICIUM-GERMANIUM/SILICIUM-STAPEL WÄHREND DER HERSTELLUNG EINES HALBLEITERBAUELEMENTS
SOLUTION DE GRAVURE PERMETTANT D'ÉLIMINER SIMULTANÉMENT DU SILICIUM ET UN ALLIAGE SILICIUM-GERMANIUM D'UN EMPILEMENT SILICIUM-GERMANIUM/SILICIUM PENDANT LA FABRICATION D'UN DISPOSITIF À SEMI-CONDUCTEUR

(30) Priority: 29.09.2017 US 201762565704 P; 26.09.2018 US 201816142291
(43) Date of publication of application: 29.07.2020
(73) Proprietor: Versum Materials US, LLC, Tempe, AZ 85284 (US)
(72) Inventor: GE, Jhih, Kuei, Tempe AZ 85284 (US); LEE, Yi-Chia, Tempe AZ 85284 (US); LIU, Wen, Dar, Tempe AZ 85284 (US); KUO, Chi-Hsien, Tempe AZ 85284 (US); ADAMCZYK, Andrew, J., Tempe AZ 85284 (US)
(74) Representative: Sommer, Andrea
(86) International application number: PCT/US2018/053304
(87) International publication number: WO 2019/067836

(56) References cited:
- EP-A1- 3 447 791
- EP-A1- 3 537 473
- WO-A1-2017/007893
- KR-A- 20170 034 036
- US-A1- 2004 242 015
- US-A1- 2017 145 311
- WOSTYN, K. ET AL.: "Selective Etch of Si and SiGe for Gate All-Around Device Architecture", ECS TRANSACTIONS, vol. 69, 2 October 2015 (2015-10-02), pages 147 - 152, XP055585538

## Description

### CROSS-REFERENCE TO RELATED APPLICATIONS

### BACKGROUND OF THE INVENTION

The present invention relates to the use of an aqueous etching solution for simultaneously removal of silicon and silicon-germanium from a microelectronic device and a method for simultaneously etching silicon and silicon germanium from a microeconomic device comprising silicon and silicon-germanium as set out in the appended set of claims.

With constant down-scaling and increasingly demanding requirements to the speed and functionality of ultra-high density integrated circuits, conventional planar metal-oxide-semiconductor field effect transistors (MOSFETs) face increasing challenges with such issues as scaling of gate oxide thickness and electrostatic control of the gate electrode over the channel region. Fin field effect transistors (FinFETs) have exhibited improved control over a planar gate MOSFET design by wrapping the gate electrode over three sides of a fin-shaped channel.

GAA MOSFETs are similar to FinFETs but have the potential of even greater electrostatic control over the channel because the gate electrode completely surrounds the channel. In a GAA MOSFET, the channel region is essentially a nanowire. The nanowire channel typically has a thickness (or diameter) in the tens of nanometers (nm) or less and has an unconstrained length. The nanowire channel is suspended generally horizontally between, and anchored to, the much larger source and drain regions of the GAA MOSFET.

GAA MOSFETs can be fabricated on a bulk silicon substrate utilizing fully compatible CMOS technology. A typical manufacturing method of forming the channel regions in a GAA MOSFET involves epitaxially growing a stack (epi-stack) of sacrificial layers sandwiched between channel layers on top of a bulk substrate. The sacrificial layers and channel layers are composed of two different materials so that selective etching can remove the sacrificial layers.

By way of example, an epi-stack can be formed of alternating silicon (Si) and silicon germanium (SiGe) layers, wherein the Si layers are the sacrificial layers and the SiGe layers are the channel layers. The Si layers can then be removed by selective etching (for example via a wet etching process such as a TMAH), which also inadvertently recesses trenches into the bulk substrate due to the similarity of materials composing the sacrificial layers and the substrate. The SiGe layers can subsequently be formed into the nanowire channels suspended over the trenches. A thin gate dielectric is then disposed around the SiGe nanowire channels and over the recessed trenches of the substrate. Metal is then disposed over the dielectric to form the metal gate electrode of the GAA MOSFET.

There are also situations when both silicon and silicon-germanium need to be etched simultaneously such as, for example, in fin trimming. The application of simultaneous Si/SiGe fin trimming is typically employed for 5 nm technology. There are two types of fin on pattern, including Si and SiGe. Because the fins would go through some process steps, if the original fin width is too narrow, it may cause fin collapse issue. Therefore, wider fins may be initially produced and then they are trimmed by a wet etch process to avoid fin collapsing. There is a need in the art for an etching chemistry that targets Si and SiGe to reduce the fin thickness to be equal to about 1 nm, and the chemistry must be compatible with oxides & nitrides. WO 2017/007 893 A1 discloses compositions useful for the selective removal of silicon germanium materials relative to germanium-containing materials and silicon-containing materials from a microelectronic device having same thereon. The removal compositions include at least one diol and are tunable to achieve the required SiGe:Ge removal selectivity and etch rates. US 2004/0242015 A1 discloses etching compositions for selectively etching silicon germanium faster than other silicon containing compositions which may be produced by controlling the ratios of de-ionized water used in the etching compositions with respect to the amounts of nitric acid, hydrofluoric acid, and/or acetic acid. Methods for selectively etching silicon germanium without damaging a silicon substrate or a silicon layer are possible using the etching compositions.

### BRIEF SUMMARY OF THE INVENTION

In one aspect, the present invention provides the use of an etching solution suitable for the simultaneous removal of silicon and silicon-germanium from a microelectronic device, which comprises water; an oxidizer; a buffer composition comprising an amine compound and a polyfunctional organic acid; a water-miscible solvent; and a fluoride ion source as set out in the appended claims.

In another aspect, the present invention provides a method for simultaneously etching silicon and silicon-germanium from a microelectronic device (composite semiconductor device) comprising silicon and silicon-germanium as set out in the appended claims. The method conditions, such as time and temperature, may be increased or decreased to modify the removal rates.

### DETAILED DESCRIPTION OF THE INVENTION

The present invention relates generally to the use of compositions useful for the selective removal of silicon and silicon-germanium from a microelectronic device having such material(s) thereon during its manufacture.

It will be understood that the term "silicon" as deposited as a material on a microelectronic device will include polysilicon.

For ease of reference, "microelectronic device" or "semiconductor device" corresponds to semiconductor substrates, for examples wafers, flat panel displays, phase change memory devices, solar panels and other products including solar substrates, photovoltaics, and microelectromechanical systems (MEMS), manufactured for use in microelectronic, integrated circuit, or computer chip applications. Solar substrates include, but are not limited to, silicon, amorphous silicon, polycrystalline silicon, monocrystalline silicon, CdTe, copper indium selenide, copper indium sulfide, and gallium arsenide on gallium. The solar substrates may be doped or undoped. It is to be understood that the term "microelectronic device" is not meant to be limiting in any way and includes any substrate that will eventually become a microelectronic device or microelectronic assembly.

A "composite semiconductor device" or "composite microelectronic device" means that the device has more than one materials and/or layers and/or portions of layers present on a non-conductive substrate. The materials may comprise high K dielectrics, and/or low K dielectrics and/or barrier materials and/or capping materials and/or metal layers and/or others known to persons of skill.

As defined herein, "low-k dielectric material" corresponds to any material used as a dielectric material in a layered microelectronic device, wherein the material has a dielectric constant less than about 3.5. Preferably, the low-k dielectric materials include low-polarity materials such as silicon-containing organic polymers, silicon-containing hybrid organic/inorganic materials, organosilicate glass (OSG), TEOS, fluorinated silicate glass (FSG), silicon dioxide, and carbon-doped oxide (CDO) glass. It is to be appreciated that the low-k dielectric materials may have varying densities and varying porosities.

As defined herein, "high-κ dielectric material" refers to a material with a high dielectric constant κ (as compared to silicon dioxide). High-κ dielectrics may be used to replace a silicon dioxide gate dielectric or another dielectric layer of a microelectronic device. The high-k material may be hafnium dioxide (HfO₂), hafnium oxynitride (HfON), zirconium dioxide (ZrO₂), zirconium oxynitride (ZrON), aluminum oxide (Al₂O₃), aluminum oxynitride (AION), hafnium silicon oxide (HfSiO₂), hafnium aluminum oxide (HfAlO), zirconium silicon oxide (ZrSiO₂), tantalum dioxide (Ta₂O₅), aluminum oxide, Y₂O₃, La₂O₃, titanium oxide (TiO₂), aluminum doped hafnium dioxide, bismuth strontium titanium (BST), or platinum zirconium titanium (PZT).

As defined herein, the term "barrier material" corresponds to any material used in the art to seal the metal lines, e.g., copper interconnects, to minimize the diffusion of said metal, e.g., copper, into the dielectric material. Preferred barrier layer materials include tantalum, titanium, ruthenium, hafnium, and other refractory metals and their nitrides and silicides.

In all such compositions, wherein specific components of the composition are discussed in reference to weight percentage ranges including a zero lower limit, it will be understood that such components may be present or absent in various specific embodiments of the composition, and that in instances where such components are present, they may be present at concentrations as low as 0.001 weight percent, based on the total weight of the composition in which such components are employed. Unless otherwise defined, all the amounts reported herein are in weight percent of the total composition, that is 100%.

The etching solution used in the invention comprises, consists essentially of, or consists of water; an oxidizer; a buffer composition comprising an amine compound and a polyfunctional organic acid; a water-miscible solvent; and a fluoride ion source as set out in the appended claims.

In some embodiments, the etching solution compositions disclosed herein are formulated to be substantially free or free of of at least one of the following chemical compounds: ammonium hydroxide, quaternary ammonium hydroxides (e.g., TMAH, TEAH, ETMAH), and inorganic bases.

The compositions of the uses and methods of the present invention are suitable for use in a process for making a gate all around structure on an electronic device. Such processes are known in the art such as, for example, the process disclosed in U.S. patent application Publication No. 2017/0179248, U.S. patent application Publication No. 2017/0104062, U.S. patent application Publication No. 2017/0133462, and U.S. patent application Publication No. 2017/0040321.

The compositions disclosed herein exhibit excellent simultaneous removal of silicon and silicon-germanium.

### Water

The etching compositions of the uses and methods of the present invention are aqueous-based and, thus, comprise water. In the present invention, water functions in various ways such as, for example, to dissolve one or more components of the composition, as a carrier of the components, as an aid in the removal of residue, as a viscosity modifier of the composition, and as a diluent. Preferably, the water employed in the cleaning composition is de-ionized (DI) water. The ranges of water described in the next paragraph include all of the water in the composition from any source.

The weight percent of water in the composition will be present in a range with start point 0.5 and end point 90. Thus, the range of water that is used in the composition is from 0.5% 90% by of water, including the start and end values. The etching solutions includes water in an amount to achieve the weight percent of the other ingredients. (Note the water ranges defined herein include the total water in the composition. The ranges, therefore, include water that is added as part of other components that may be for example, added as an aqueous solution to the composition.)

### Oxidizer

The etching compositions of the use and the methods of the present invention comprise an oxidizing agent, also referred to as an "oxidizer." The oxidizer functions primarily to etch the silicon and the silicon-germanium alloy by forming a corresponding oxide (i.e., germanium or silicon).

The oxidizing agents are selected from the group consisting of hydrogen peroxide, periodic acid, potassium iodate, potassium permanganate, ammonium persulfate, ammonium molybdate, ferric nitrate, nitric acid, potassium nitrate, ammonia, and mixtures thereof. In still other embodiments, oxidizing agents include hydrogen peroxide and urea-hydrogen peroxide. In some embodiments, the oxidizing agent is hydrogen peroxide.

The amount of oxidizer (neat) will comprise from 0.1% to 20% by weight, preferably from about 1.0 % to 20% by weight, or from about 1.5% to about 15% by weight, or from 1.5 % to about 10% by weight, or from 2% to about 10% by weight of the composition based on the total weight of the composition having start and end points preferably selected from: 0.3, 0.5, 1, 1.5, 2, 2.5, 3, 3.5, 4, 4.5, 5, 5.5, 6, 7, 8, 9, 10 and 15.

### Fluoride Ion Source

The etching compositions of the present disclosure also comprise one or more sources of fluoride ion. Fluoride ion functions principally to assist in removal of silicon and germanium oxide that has formed upon action of the oxidizer. The fluoride ion source is selected from the group consisting of hydrofluoric acid, ammonium fluoride, quaternary ammonium fluoroborates, fluoroboric acid, quaternary ammonium hexafluoroaluminates and a fluoride salt of an aliphatic primary, secondary or tertiary amine having the formula R¹NR²R³R⁴F, wherein R¹,R²,R³ and R⁴ individually represent H or a C₁-C₄ alkyl group. Typical compounds that provide a fluoride ion source according to the present invention are hydrofluoric acid, ammonium fluoride, quaternary ammonium fluorides such as, for example, fluoroborates, fluoroboric acid, tetrabutylammonium tetrafluoroborate, aluminum hexafluoride, and a fluoride salt of an aliphatic primary, secondary or tertiary amine having the formula:

R¹NR²R³R⁴F,

wherein R¹, R², R³ and R⁴ individually represent H or a (C₁-C₄) alkyl group. Typically, the total number of carbon atoms in the R¹, R², R³ and R⁴ groups is 12 carbon atoms or less. Examples of fluoride salts of an aliphatic primary, secondary or tertiary amine such as, for example, tetramethylammonium fluoride, tetraethylammonium fluoride, methyltriethylammonium fluoride, and tetrabutylammonium fluoride.

In selecting the source of the fluoride ion, consideration should be given as to whether or not the source releases ions that would adversely affect the surface being cleaned. For example, in cleaning semiconductor elements, the presence of sodium or calcium ions in the cleaning composition can have an adverse effect on the surface of the element. In some embodiments, the fluoride ion source is ammonium fluoride.

The amount of the compound used as the source of the fluoride ion in the cleaning composition is from 0.01 10% by weight. Preferably from 0.01 to about 8% by weight of a solution 40% ammonium fluoride, or stoichiometric equivalent thereof. Preferably, the compound comprises from about 0.02 to about 8% by weight, more preferably from about 0.02 to about 6% by weight, still more preferably, about 1 to about 8% by weight, and most preferably, from about 0.025% to about 5% by weight of a solution of about 40% ammonium fluoride. (Typically the ammonium fluoride solution is an aqueous solution.) In some embodiments, the composition will comprise from about 0.01 to about 8% by weight or about 0.01 to about 7% by weight of a fluoride ion source, which may be provided by a 40% ammonium fluoride solution. Preferably, the compound comprises from about 0.02 to about 6% by weight of a fluoride ion source and, most preferably, from about 0.025% to about 5% or from about 0.04 to about 2.5% by weight of a fluoride ion source or from about 0.05 to about 15% by weight of a solution of 40% ammonium fluoride, most preferably, from about 0.0625% to about 12.5%, or from about 0.1 to about 6.25% by weight of a solution of 40% ammonium fluoride. The % by weight of a solution of 40% ammonium fluoride that may be added to the composition include any range having start and endpoints selected from the following group of numbers: 0.01, 0.02, 0.025, 0.04, 0.05, 0.06, 0.5, 0.6, 0.75, 0.1, 0.2, 0.5, 0.6, 0.75. 1, 2, 2.5, 3, 3.5, 4, 5, 6, 7, 8, 10, 12.5, 15, 17, 18, and 20. The % by weight of fluoride ion source (neat) that may be added to the composition includes any range having start and endpoints selected from the following group of numbers: 0.01, 0.02, 0.025, 0.04, 0.05, 0.06, 0.5, 0.6, 0.75, 0.1, 0.2, 0.5, 0.6, 0.75, 1, 1.2, 1.4, 1.6, 1.8, 2, 2.2, 2.5, 2.7, 3, 3.5, 4, 4.5, 5, 5.5, 6, 7, 8, 10, 12.5, 15, 17, 18, 20, 25, 30, 35, 40, 45 and 50. The % by weight of fluoride ion source (neat) that may be added to the composition includes, for examples, from about 0.025% to about 5%, or from about 0.04 to about 2.5%, or from about 0.1% to about 2%, or from about 0.5 to about 1.5% by weight of a fluoride ion source.

It should be understood that the amount of fluoride ion used will typically depend, however, on the particular substrate being cleaned. For example, in certain cleaning applications, the amount of the fluoride ion can be relatively high when cleaning substrates that comprise dielectric materials that have a high resistance to fluoride etching. Conversely, in other applications, the amount of fluoride ion should be relatively low, for example, when cleaning substrates that comprise dielectric materials that have a low resistance to fluoride etching.

### Water-Miscible Solvent

The etching compositions of the uses and methods of the present invention comprise a water-miscible solvent. The water-miscible solvent may function to inhibit the silicon etch rate and to boost the silicon-germanium etch rate. Organic solvents that are be employed are hexyloxypropylamine, poly(oxyethylene)diamine, dimethylsulfoxide (DMSO), and sulfoxides. Preferred solvents are alcohols, diols, or mixtures thereof. Most preferred solvents are diols such as, for example, butyl diglycol.

Alternatively, the water-miscible organic solvent comprises a glycol ether. Examples of glycol ethers include ethylene glycol monomethyl ether, ethylene glycol monoethyl ether, ethylene glycol monobutyl ether, ethylene glycol dimethyl ether, ethylene glycol diethyl ether, diethylene glycol monomethyl ether, diethylene glycol monoethyl ether, diethylene glycol monopropyl ether, diethylene glycol monoisopropyl ether, diethylene glycol monobutyl ether, diethylene glycol monoisobutyl either, diethylene glycol monobenzyl ether, diethylene glycol dimethyl ether, diethylene glycol diethyl ether, triethylene glycol monomethyl ether, triethylene glycol dimethyl ether, polyethylene glycol monomethyl ether, diethylene glycol methyl ethyl ether, triethylene glycol methyl ethyl ether, ethylene glycol monomethyl ether acetate, ethylene glycol monethyl ether acetate, propylene glycol methyl ether acetate, propylene glycol monomethyl ether, propylene glycol dimethyl ether, propylene glycol monobutyl ether, propylene glycol, monopropyl ether, dipropylene glycol monomethyl ether (DPM), dipropylene glycol monopropyl ether, dipropylene glycol monoisopropyl ether, dipropylene monobutyl ether, diproplylene glycol diisopropyl ether, tripropylene glycol monomethyl ether, 1-methoxy-2-butanol, 2-methoxy-1-butanol, 2-methoxy-2-methylbutanol, 1,1-dimethoxyethane and 2-(2-butoxyethoxy) ethanol.

For application in the present invention, the amount of water-miscible organic solvent in the composition is in a range having start point 0.5 and end point 59.5. Start and end points preferably are selected from the following list of weight percents: 1, 5, 7, 9, 12, 15, 20, 25, 28, 30, 35, 40, 45, 50. Examples of such ranges of solvent include from about 1% to about 50% by weight; or from 0.5% to about 50%, or from about 1% to about 40% by weight; or from 0.5% to about 30% by weight; or from about 1% to about 30% by weight; or from about 5% to about 30% by weight; or from about 5% to about 15% by weight; or from about 7% to about 12%, or from about 10% to about 25%, or from about 15% to about 25% by weight of the composition.

### Amine Compound

Compositions of the uses and methods of the present invention comprise an amine compound which may function in one or more of the following roles: as a pH adjustor, a complexing agent and/or as the conjugate base in a buffer composition, preferably predominantly as a pH adjustor. The amine compounds include at least one alkanolamine. Preferred alkanolamines include the lower alkanolamines which are primary, secondary and tertiary having from 1 to 5 carbon atoms. Examples of such alkanolamines include N-methylethanolamine (NMEA), monoethanolamine (MEA), diethanolamine, mono-, di- and triisopropanolamine, 2-(2-aminoethylamino)ethanol, 2-(2-aminoethoxy)ethanol, triethanolamine, N-ethyl ethanolamine, N,N-dimethylethanolamine, N,N-diethyl ethanolamine, N-methyl diethanolamine, N-ethyl diethanolamine, cyclohexylaminediethanol, and mixtures thereof.

In preferred embodiments, the amine compound is an alkanolamine selected from the group consisting of triethanolamine (TEA), diethanolamine, N-methyl diethanolamine, diisopropanolamine, monoethanol amine, amino(ethoxy) ethanol (AEE), N-methyl ethanol amine, monoisopropanol amine, cyclohexylaminediethanol, and mixtures thereof.

It is believed that the amount of the amine compound in the composition will, for the most applications, comprise from about 0.01% to about 50% by weight of the composition, specifically, about 0.08% to about 40% by weight of the composition, or more specifically, about 0.2% to about 30% by weight of the composition. In some embodiments, the amine compound comprises from about 0.02% to about 15% weight percent and, more specifically, from about 0.03 to about 12% or about from 0.3 to about from 7% by weight or about from 0.1 to about from 3% by weight of the composition. The weight percent of amine in the composition may be present in a range with start and end points selected from the following group of numbers: 0.01, 0.02, 0.03, 0.04, 0.05, 0.7, 0.09. 0.1, 0.2, 0.3, 0.5, 0.7, 0.9, 1, 1.2, 1.5, 1.7, 2, 2.5, 3, 3.5, 5, 7, 10, 12, 15, 20, 25, 30, 35, 40, 45 and 50.

The amine compound, if employed in excess may also serve as the base component of the buffer comprising the polyfunctional organic acid.

### Buffer

The etching compositions include a buffer composition. The buffer composition comprises, consists essentially of, or consists of an amine compound (as detailed above) and the polyfunctional organic acid as detailed below. In addition to the amine compound, additional bases and/or ammonium salts may be added to the composition to work with the polyfunctional organic acid to buffer the composition.

The buffer employed comprises ammonium salts paired with one or more polyfunctional organic acids, which function primarily as the conjugate acid portion of the buffer. As used herein, the term "polyfunctional organic acid" refers to an acid or a multi-acid that has more than one carboxylate group, including but not limited to, (i) dicarboxylate acids (such as malonic acid, malic acid, et al); dicarboxylic acids with aromatic moieties (such as phthalic acid et al), and combinations thereof; and (ii) tricarboxylic acids (such as citric acid et al), tricarboxylic acids with aromatic moieties (such as trimellitic acid, et al), and combinations thereof.

Preferred acids for the buffer system are polyprotic that have at least three carboxylic acid groups. Such acids have at least a second and a third dissociation constant, each of which is higher relative to its respective preceding constant. This indicates that the acid loses a first proton more easily than a second one, because the first proton separates from an ion of a single negative charge, whereas the second proton separates from the ion of a double negative charge. It is believed that the double negative charge strongly attracts the proton back to the acid ion. A similar relationship exists between the second and third separated protons. Thus, polyprotic acids such as, for example, those having at least three carboxylic acid groups are useful in controlling the pH of a solution, particularly at a pH corresponding to their higher pKa value. Therefore, in addition to having a pKa value of about 5 to about 7, preferred polyprotic acids of the present invention have multiple pKa values, wherein the highest pKa is from about 5 to about 7, or from about 5 to about 6, or from about 6 to about 7, or from about 5.5 to about 6.5.

Polyprotic acids having at least three carboxylic acid groups according to the present invention are highly compatible with polyhydric solvents. Examples of preferred polyprotic acids include tricarboxylic acids (e.g., citric acid, 2-methylpropane-1,2,3-triscarboxylic, benzene-1,2,3-tricarboxylic [hemimellitic], propane-1,2,3-tricarboxylic [tricarballylic], 1,cis-2,3-propenetricarboxylic acid [aconitic], and the like), tetracarboxylic acids (e.g., butane-1,2,3,4-tetracarboxylic, cyclopentanetetra-1,2,3,4-carboxylic, benzene-1,2,4,5-tetracarboxylic [pyromellitic], and the like), pentacarboxlyic acids (e.g., benzenepentacarboxylic), and hexacarboxylic acids (e.g., benzenehexacarboxylic [mellitic]), and the like. The respective pKa values of these acids are provided in Table 1. Particularly preferred polyprotic acids include tricarboxylic acids, with citric acid being most preferred.

**TABLE 1**

| **Acid** | ***pKa value at 25° C*** | | | | | |
|---|---|---|---|---|---|---|
| | *pK1* | *pK2* | *pK3* | *pK4* | *pK5* | *pK6* |
| Citric acid | 3.13 | 4.76 | 6.40 | | | |
| 2-Methylpropane-1,2,3-triscarboxylic | 3.53 | 5.02 | 7.20 | | | |
| Benzene-1,2,3-tricarboxylic (hemimellitic) | 2.98 | 4.25 | 5.87 | | | |
| Propane-1,2,3-tricarboxylic (tricarballylic) | 3.67 | 4.84 | 6.20 | | | |
| 1 ,cis-2,3-Propenetricarboxylic acid, (aconitic) | 3.04 | 4.25 | 5.89 | | | |
| Butane-1,2,3,4-tetracarboxylic | 3.36 | 4.38 | 5.45 | 6.63 | | |
| Cyclopentanetetra-1,2,3,4-carboxylic | 3.07 | 4.48 | 5.57 | 10.06 | | |
| Benzene-1,2,4,5-tetracarboxylic (pyromellitic) | 2.43 | 3.13 | 4.44 | 5.61 | | |
| Benzenepentacarboxylic | 2.34 | 2.95 | 3.94 | 5.07 | 6.25 | |
| Benzenehexacarboxylic (mellitic) | 2.08 | 2.46 | 3.24 | 4.44 | 5.50 | 6.59 |

Citric acid, the preferred polyprotic acid, is a tricarboxylic acid having three pKa values: 3.13, 4.76, and 6.40, corresponding to trihydrogencitrate ions, dihydrogencitrate ions, and monohydrogen citrate ions, respectively. In certain preferred embodiments of the present invention, the buffer system comprises a salt of citric acid, with especially preferred buffers comprising aqueous solutions of ammonium citrate tribasic and citric acid.

The polyfunctional acid component of the buffer, in combination with the ammonium salts containing component of the buffer, exerts a buffering action on the composition of the present invention. When the above-mentioned acids are reacted with the ammonium base according to the embodiment, they form, for example, ammonium chloride, ammonium sulfate, ammonium nitrate, ammonium carbonate, ammonium hypochlorite, ammonium chlorate, ammonium permanganate, ammonium acetate, dibasic ammonium phosphate, diammonium citrate, triammonium citrate (TAC), ammonium sulfamate, ammonium oxalate, ammonium formate, ammonium tartrate, ammonium bitartrate and ammonium glycolate. In some embodiments, one or more of the above-listed ammonium salts may be added to the composition as part of the buffer (in addition to the polyfunctional acid) to buffer the composition. In those embodiments the buffer may comprise the one or more than one ammonium salt and the one or more than one polyfunctional acid.

It is believed that the amount of polyfunctional organic acid in the compositions of the present disclosure will be from about 0.1 wt% to about 5 wt%, or from about 0.25 wt% to about 3 wt%, or from about 0.3 wt% to about 2.5 wt%, or from about 0.5 wt% to about 2 wt%, or from about 0.3 to about 2 wt%, or from about 0.3 to about 1.5 wt%, or from about 0.1 wt% to about 1 wt%. The weight percent of the polyfunctional organic acid in the composition may be present in a range with start and end points selected from the following group of numbers: 0.01, 0.02, 0.03, 0.04, 0.05, 0.7, 0.09. 0.1, 0.2, 0.3, 0.5, 0.7, 0.9, 1, 1.5, 2, 2.5, 3, 5, 7, 10, 15 and 20. The amount of the base, amine, and/or ammonium salt that acts as the buffer with the polyfunctional organic acid may be present in the composition in an amount that from 1:10 to 10:1, or from 1:8 to 8:1, or from 1:5 to 5:1, or from 1:3 to 3:1, or from 1:2 to 2:1, or from 1.5:1 to 1:1.5, or from 1.3:1 to 1:1.3 or from 1.1:1 to 1:1.1 the weight of the polyfunctional organic acid.

Preferably, the buffer composition of the disclosed etching compositions buffer the compositions so they are alkaline. In some embodiments, the pH is from 2 to 12. In other embodiments, the pH is from 2 to 10. In other embodiments, the pH is from 3 to 9. In other embodiments the pH may be within a range with start and end points selected from the following group of pH values: 2, 3, 3.5, 4, 4.5, 5, 5.5, 6, 6.5, 7, 7.5, 8, 8.5, 9, 9.5, 10, 10.5, 11, 11.5, 12, 13. 13.5.

### Other Optional Ingredients

The etching composition of the uses and the methods of the present invention may also include one or more of the following additives: chelating agents, chemical modifiers, dyes, biocides, and other additives. The additive(s) may be added to the extent that they do not adversely affect the performance of the composition.

Another optional ingredient that can be used in the etching composition is a metal chelating agent; it can function to increase the capacity of the composition to retain metals in solution and to enhance the dissolution of metallic residues. Typical examples of chelating agents useful for this purpose are the following organic acids and their isomers and salts: ethylenediaminetetraacetic acid (EDTA), butylenediaminetetraacetic acid, (1,2-cyclohexylenediamine)tetraacetic acid (CyDTA), diethylenetriaminepentaacetic acid (DETPA), ethylenediaminetetrapropionic acid, (hydroxyethyl)ethylenediaminetriacetic acid (HEDTA), N, N,N', N'-ethylenediaminetetra(methylenephosphonic) acid (EDTMP), triethylenetetraminehexaacetic acid (TTHA), 1,3-diamino-2-hydroxypropane-N,N,N',N'-tetraacetic acid (DHPTA), methyliminodiacetic acid, propylenediaminetetraacetic acid, nitrotriacetic acid (NTA), tartaric acid, gluconic acid, saccharic acid, glyceric acid, oxalic acid, phthalic acid, maleic acid, mandelic acid, malonic acid, lactic acid, salicylic acid, propyl gallate, pyrogallol, 8-hydroxyquinoline, and cysteine. Preferred chelating agents are aminocarboxylic acids such as EDTA, CyDTA and aminophosphonic acids such as EDTMP.

It is believed that the chelating agent, if present, will be in the composition in an amount of from about 0.1 wt. % to about 10 wt. %, preferably in an amount of from about 0.5 wt. % to about 5 wt. % of the composition.

In some embodiments the compositions of the uses and methods of this invention will be free of or substantially free of any or all or some (in any combination) of the above-listed chelating agents added to the composition.

Other commonly known components such as dyes, biocides etc. can be included in the cleaning composition in conventional amounts, for example, amounts up to a total of about 5 weight % of the composition. In other embodiments the composition will be substantially free of or free of dyes and biocides.

In other embodiments, the etching solution will be substantially free of (or free of) sodium and/or calcium. In some embodiments, the compositions disclosed herein are formulated to be substantially free of at least one of the following chemical compounds: inorganic acids, alkyl thiols, and organic silanes. In some embodiments, the compositions disclosed herein are formulated to be substantially free or free of inorganic bases. In some embodiments, the composition is free of chelating agents, such as EDTA and/or corrosion inhibitors, such as triazoles. In some embodiments, the composition may be substantially free of or free of one or more of the following: hydroxides, metal hydroxides, such as KOH or LiOH or NaOH. In other embodiments, the composition may be substantially free of or free of a halide-containing compound other than one or more fluorine-containing compounds, for example it may be substantially free or free of one or more of the following: bromine-, chlorine- or iodine-containing compounds. In other embodiments, the composition may be substantially free or free of sulfonic acid and/or phosphoric acid and/or sulfuric acid and/or nitric acid and/or hydrochloric acid. In other embodiments, the composition may be substantially free or free of sulfates and/or nitrates and/or sulfites and/or nitrites. In other embodiments, the composition may be substantially free or free of: ammonium hydroxide and/or ethyl diamine. In other embodiments, the composition may be substantially free or free of: sodium-containing compounds and/or calcium-containing compounds and/or manganese-containing compounds or magnesium-containing compounds and/or chromium-containing compounds and/or sulfur-containing compounds and/or silane-containing compounds and/or phosphorus-containing compounds. In some embodiments the composition may be substantially free of or free of nonionic and/or anionic, and/or cationic surfactants, and/or polyethyleneimines.

The etching solution composition of the uses and methods of the present invention is typically prepared by mixing the components together in a vessel at room temperature until all solids have dissolved in the aqueous-based medium.

### Method

An additional drying step may also be included in the method. "At least partially removed" means removal of at least 50% of the material, preferably at least 70% removal. Most preferably, at least 80% removal using the compositions of the present invention.

The silicon may be in any orientation such as, for example (100) or (110). In some embodiments, the orientation of the silicon is (110) and in other embodiments the orientation of the silicon is (100).

The contacting step can be carried out by any suitable means such as, for example, immersion, spray, or via a single wafer process. The temperature of the composition during the contacting step is preferably from about 25 to 200 °C and more preferably from about 25 to 100 °C and, more preferably, from about 25 to 100 °C.

Compositions of the uses and methods of the present invention surprisingly exhibit excellent simultaneous etch for silicon and silicon-germanium when used on substrates that include silicon and silicon-germanium such as, for example, during the manufacture of a stacked gate all around device. In some embodiments, the etch rate of silicon and silicon-germanium can be from 1:2.5 to 2.5:1, or 1:2 to 2:1, or 1.9:1 to 1:1.9, or 1.8:1 to 1:1.8, or 1.7:1 to 1:1.7, or 1.6:1 to 1:1.6, or 1.5:1 to 1:1.5, or 1.4:1 to 1:1.4, or 1.3:1 to 1:1.3, or 1.2:1 to 1:1.2, or 1.1:1 to 1:1.1. In other embodiments, the etch rate of silicon and silicon-germanium can be about 1:1. The removal rate ratios are measured in the change in thickness (for example of a fin) before and after treatment.

After the contacting step is a rinsing step. The rinsing step may be carried out by any suitable means, for example, rinsing the substrate with de-ionized water by immersion or spray techniques. In preferred embodiments, the rinsing step may be carried out employing a mixture of de-ionized water and an organic solvent such as, for example, isopropyl alcohol.

After the contacting step and the rinsing step is an optional drying step that is carried out by any suitable means, for example, isopropyl alcohol (IPA) vapor drying, heat, by centripetal force or by directing clean dry air or inert gas and/or combinations thereof.

The features and advantages are more fully shown by the illustrative examples discussed below.

### EXAMPLES

### General Procedure for Preparing the Cleaning Compositions

All compositions which are the subject of the uses and methods of the present Examples were prepared by mixing the components in a 250 mL beaker with a 1" Teflon-coated stir bar. Typically, the first material added to the beaker was deionized (DI) water followed by the other components in no particular order.

### Compositions of the Substrate

Si or SiGe blanket wafers were used to check the etch rate for formulation development. A patterned wafer with Si and SiGe fins was used to confirm the fin trimming using a composition of this invention.

### Processing Conditions

Etching tests of silicon and SiGe were run using 100g of the etching compositions in a 250 ml beaker with a ½" round Teflon stir bar set at 400 rpm. The etching compositions were heated to a temperature of about 45 °C on a hot plate (typically from 25 °C to 80 °C). The test coupons were immersed in the compositions for about 20 minutes while stirring.

The segments were then rinsed for 3 minutes in a DI water bath or sprayed and subsequently dried using filtered nitrogen. The silicon and silicon-germanium etch rates were estimated from changes in the thickness before and after etching and was measured by Transmission Electron Microscope.

### Examples

**Table 1 lists compositions evaluated.**

| Raw Material | RM Assay, wt% | Example 1 | Example 2 | Example 3 |
|---|---|---|---|---|
| H2O2 (30%) | 30 | 10.00 | 5.00 | 2.00 |
| TAC | 100 | 0.60 | 0.60 | 0.60 |
| Citric acid | 100 | 0.50 | 0.50 | 0.50 |
| DIW | | 65.80 | 89.80 | 88.80 |
| NH4F (40%) | 40 | 2.50 | 3.50 | 2.50 |
| AEE | | 0.60 | 0.60 | 0.60 |
| BDG | | 20.00 | 0.00 | 5.00 |
| Total | | 100.00 | 100.00 | 100.00 |

Referring to Table 2, the compositions of Table 1 were employed at a process temperature of 25 °C and a process time of 50 seconds and Example 2 was also tested at 90 seconds. The Si trimming thickness was 0.9 nm and the SiGe trimming was 1.2 nm for the Example 1 composition providing a removal rate ratio of Si:SiGe of 1:1.33. Example 2 after 50 seconds provided a Si trimming thickness of 4.5 nm and a SiGe trimming of 1.9 nm providing a removal rate ratio of SiGe:Si of 1:2.36. Example 3 provided a Si:SiGe removal rate of 1:1.11. The trimming thickness of Examples 1 and 3 were both approximately 1 nm. Additionally,the compositions were compatible with oxide and nitride. Example 2 at 90 seconds removed 100% of both the Si and SiGe. The process times can be modified to improve the results.

**Table 2: Conditions and Results**

| Chemical | Temp. (C) | Fin | Before (nm) | Process time (s) | After (nm) | Trimming Thickness (nm) | Oxide E/R (A/min) | SiN E/R (A/min) |
|---|---|---|---|---|---|---|---|---|
| Example 1 | 25 | Si | 6.5-8.1 | 50 | 5.9-6.8 | 0.9 | <1 | <1 |
| | | SiGe | 4.9-5.7 | 50 | 3.3-4.9 | 1.2 | | |
| Example 2 | 25 | Si | 6.3-7.9 | 50 | 2.3-2.9 | 4.5 | <1 | <1 |
| | | SiGe | 5.2-6.3 | 50 | 3.4-4.2 | 1.9 | | |
| Example 2 | 25 | Si | 6.3-7.9 | 90 | 0 | >7.1 | <1 | <1 |
| | | SiGe | 5.2-6.3 | 90 | 0 | >5.8 | | |
| Example3 | 40 | Si | 6.3-7.9 | 50 | 5.4-7.0 | 0.9 | <1 | <1 |
| | | SiGe | 5.2-6.3 | 50 | 4.2-5.3 | 1.0 | | |

### Comparative Examples:

Etching tests were run using 100g of comparative compositions in a 250 ml beaker with a ½" round Teflon stir bar set at 400 rpm. The etching compositions were heated to a temperature of about 45 °C on a hot plate. The test coupons were immersed in the compositions for about 20 minutes while stirring.

Wafers having alternating layers of Si and SiGe fins were then rinsed for 3 minutes in a DI water bath or spray and subsequently dried using filtered nitrogen. The silicon and silicon-germanium etch rates were estimated from changes in the thickness before and after etching and was measured by spectroscopic ellipsometry (MG-1000, Nano-View Co., Ltd., South Korea we use SCI FilmTek SE2000). Typical starting layer thickness was 1000 Å for Si and 1000 Å for SiGe.

Table 3 shows the selectivity of poly Si and SiGe for the Comparative Examples The etch rates of poly Si to SiGe were more than 3.4:1.

**Table 3: Comparative Examples**

| | 294F | 294C | 294E | 294G | 294I | 294D | 294H |
|---|---|---|---|---|---|---|---|
| ETMAH (20%) | 15 | 15 | 15 | 15 | 15 | 15 | 15 |
| DIW | 39.7 | 39.7 | 39.7 | 39.7 | 39.7 | 39.7 | 39.7 |
| AEE | 25 | 25 | 25 | 25 | 25 | 25 | 25 |
| Lupasol 800 | 0.3 | | | | | | |
| Glycerol | 20 | | | | | | |
| DMSO | | 20 | | | | | |
| PG | | | 20 | | | | |
| DPM | | | | 20 | | | |
| DIW | | | | | 20 | | |
| sulfolane | | | | | | 20 | |
| BDG | | | | | | | 20 |
| poly Si e/r at 45 °C | 150.3 | 145.2 | 123.2 | 90.5 | 220 | 133 | 84.6 |
| SiGe e/r at 45 °C | 16.6 | 17.4 | 17.8 | 14.4 | 35 | 27.6 | 25.2 |
| Poly Si/SiGe selectivity | 9.1 | 8.3 | 6.9 | 6.3 | 6.3 | 4.8 | 3.4 |

Lupasol^{®} 800 which is supplied by BASF is a polyethyleneimine.

Although the foregoing description has been shown and described in detail with respect to the embodiments, it should be understood by those skilled in the art that various changes in form and detail are possible as long as they fall within the scope of the appended claims. Although the invention has been shown and described in detail with respect to the embodiments, it should be understood by those skilled in the art that various changes and additions in form and detail are possible as long as they fall within the scope of the appended claims. Although the invention has been shown and described in detail with respect to the embodiments, it should be understood by those skilled in the art that various changes and additions in form and detail are possible as long as they fall within the scope of the appended claims.

## Claims

1. Use of an etching solution suitable for the simultaneous removal of silicon and silicon-germanium from a microelectronic device comprising silicon and silicon-germanium, wherein the use comprises etching with an etch rate for silicon relative to silicon-germanium from 3:1 to 1:3 and where the etching solution comprises:
0.5% to 90% by weight of water;
0.1% to 20% by weight of an oxidizer, which is selected from the group consisting of hydrogen peroxide, periodic acid, potassium iodate, potassium permanganate, ammonium persulfate, ammonium molybdate, ferric nitrate, nitric acid, potassium nitrate, ammonia, and mixtures thereof or which is urea-hydrogen peroxide;
a buffer composition comprising an amine compound and a polyfunctional organic acid, wherein the amine compound includes at least one alkanolamine;
0.5% to 59.5% by weight of a water-miscible solvent, selected from the group consisting of hexyloxypropylamine, poly(oxyethylene)diamine, alcohols, sulfoxides, and mixtures thereof or selected from glycol ethers; and
0.01 to 10% by weight of a fluoride ion source, selected from the group consisting of hydrofluoric acid, ammonium fluoride, quaternary ammonium fluoroborates, fluoroboric acid, quaternary ammonium hexafluoroaluminates and a fluoride salt of an aliphatic primary, secondary or tertiary amine having the formula R¹NR²R³R⁴F, wherein R¹,R²,R³ and R⁴ individually represent H or a C₁-C₄ alkyl group.

2. A method for simultaneously etching silicon and silicon-germanium from a microelectronic device comprising silicon and silicon-germanium, the method comprising the steps of:
contacting the microelectronic device comprising silicon and silicon-germanium with an etching solution; and
rinsing the microelectronic device after the silicon and silicon-germanium are at least partially removed, wherein the etch rate for silicon relative to silicon-germanium is from 3:1 to 1:3,
wherein the etching solution comprises:
0.5% to 90% by weight of water;
0.1% to 20% by weight of an oxidizer, which is selected from the group consisting of hydrogen peroxide, periodic acid, potassium iodate, potassium permanganate, ammonium persulfate, ammonium molybdate, ferric nitrate, nitric acid, potassium nitrate, ammonia, and mixtures thereof or which is urea-hydrogen peroxide;
a buffer composition comprising an amine compound and a polyfunctional organic acid, wherein the amine compound includes at least one alkanolamine;
0.5% to 59.5% by weight of a water-miscible solvent, selected from the group consisting of hexyloxypropylamine, poly(oxyethylene)diamine, alcohols, sulfoxides, and mixtures thereof or from glycol ethers; and
0.01 to 10% by weight of a fluoride ion source, selected from the group consisting of hydrofluoric acid, ammonium fluoride, quaternary ammonium fluoroborates, fluoroboric acid, quaternary ammonium hexafluoroaluminates and a fluoride salt of an aliphatic primary, secondary or tertiary amine having the formula R¹NR²R³R⁴F, wherein R¹,R²,R³ and R⁴ individually represent H or a C₁-C₄ alkyl group.

3. The use of claim 1 or the method of claim 2, wherein the buffer composition comprises additionally an ammonium salt.

4. The use or the method of any of the preceding claims wherein the oxidizer is hydrogen peroxide.

5. The use or the method of any of the preceding claims wherein the amine compound is an alkanolamine compound selected from the group consisting of N-methylethanolamine, monoethanolamine, diethanolamine, triethanolamine, triisopropanolamine, 2-(2-aminoethylamino)ethanol, 2-(2-aminoethoxy)ethanol, triethanolamine, N-ethyl ethanolamine, N,N-dimethylethanolamine, N,N-diethyl ethanolamine, N-methyl diethanolamine, N-ethyl diethanolamine, cyclohexylaminediethanol, diisopropanolamine, cyclohexylaminediethanol, and mixtures thereof.

6. The use or the method of any of the preceding claims wherein alkanolamine is amino(ethoxy) ethanol.

7. The use or the method of any of the preceding claims wherein the water-miscible solvent is selected from the group consisting of ethylene glycol, propylene glycol, 1,4-butanediol, tripropylene glycol methyl ether, propylene glycol propyl ether, diethylene glycol n-butyl ether, hexyloxypropylamine, poly(oxyethylene)diamine, dimethylsulfoxide, tetrahydrofurfuryl alcohol, glycerol, and butyl diglycerol.

8. The use or the method of any of claims 1 to 6 wherein the water miscible solvent is selected from the list consisting of ethylene glycol monomethyl ether, ethylene glycol monoethyl ether, ethylene glycol monobutyl ether, ethylene glycol dimethyl ether, ethylene glycol diethyl ether, diethylene glycol monomethyl ether, diethylene glycol monoethyl ether, diethylene glycol monopropyl ether, diethylene glycol monoisopropyl ether, diethylene glycol monobutyl ether, diethylene glycol monoisobutyl ether, diethylene glycol monobenzyl ether, diethylene glycol dimethyl ether, diethylene glycol diethyl ether, triethylene glycol monomethyl ether, triethylene glycol dimethyl ether, polyethylene glycol monomethyl ether, diethylene glycol methyl ethyl ether, triethylene glycol methyl ethyl ether, ethylene glycol monomethyl ether acetate, ethylene glycol monoethyl ether acetate, propylene glycol methyl ether acetate, propylene glycol monomethyl ether, propylene glycol dimethyl ether, propylene glycol monobutyl ether, propylene glycol monopropyl ether, dipropylene glycol monomethyl ether (DPM), dipropylene glycol monopropyl ether, dipropylene glycol monoisopropyl ether, dipropylene monobutyl ether, dipropylene glycol diisopropyl ether, tripropylene glycol monomethyl ether, 1-methoxy-2-butanol, 2-methoxy-1-butanol, 2-methoxy-2-methylbutanol, 1,1-dimethoxyethane and 2-(2-butoxyethoxy) ethanol.

9. The use or the method of any of claims 1 to 6 wherein the water miscible solvent is selected from the list consisting of ethylene glycol dimethyl ether, ethylene glycol diethyl ether, diethylene glycol monomethyl ether, diethylene glycol monoethyl ether, diethylene glycol monopropyl ether, diethylene glycol monoisopropyl ether, diethylene glycol monobutyl ether, diethylene glycol monoisobutyl ether, diethylene glycol monobenzyl ether, diethylene glycol dimethyl ether, diethylene glycol diethyl ether, triethylene glycol monomethyl ether, triethylene glycol dimethyl ether, polyethylene glycol monomethyl ether, diethylene glycol methyl ethyl ether, triethylene glycol methyl ethyl ether, ethylene glycol monomethyl ether acetate, ethylene glycol monoethyl ether acetate, propylene glycol methyl ether acetate, propylene glycol dimethyl ether, dipropylene glycol monomethyl ether, dipropylene glycol monopropyl ether, dipropylene glycol monoisopropyl ether, dipropylene monobutyl ether, diproplylene glycol diisopropyl ether, tripropylene glycol monomethyl ether, and 2-(2-butoxyethoxy) ethanol.

10. The use or the method of any of claims 1 to 6 wherein the water-miscible solvent is diethylene glycol monobutyl ether.

11. The use or the method of any of claims 1 to 6 wherein the water-miscible solvent is butyl diglycerol.

12. The use or the method of any of the preceding claims, wherein the polyfunctional organic acid is a polyprotic acid having at least three carboxylic acid groups.

13. The use or the method of any of the preceding claims, wherein the polyfunctional acid is selected from the group consisting of citric acid, 2-methylpropane-1,2,3-triscarboxylic acid, benzene-1,2,3-tricarboxylic acid, propane-1,2,3-tricarboxylic acid, 1,cis-2,3-propenetricarboxylic acid, butane-1,2,3,4-tetracarboxylic acid, cyclopentanetetra-1,2,3,4-carboxylic, benzene-1,2,4,5-tetracarboxylic acid, benzenepentacarboxylic acid, and benzenehexacarboxylic acid, and mixtures thereof.

14. The use or the method of any of the preceding claims wherein the buffer comprises an ammonium salt selected from the group consisting of ammonium chloride, ammonium sulfate, ammonium nitrate, ammonium carbonate, ammonium hypochlorite, ammonium chlorate, ammonium permanganate, ammonium acetate, dibasic ammonium phosphate, diammonium citrate, triammonium citrate, ammonium sulfamate, ammonium oxalate, ammonium formate, ammonium tartrate, ammonium bitartrate and ammonium glycolate.

15. The use or the method of claim 14 wherein the buffer comprises triammonium citrate.

16. The method of any of claims 2 to 15 further comprising the step of drying the microelectronic device.

17. The method of any of claims 2 to 15 wherein the etch rate for silicon relative to silicon-germanium is from 2:1 to 1:2.

18. The method of any of claims 2 to 15 wherein the etch rate for silicon relative to silicon-germanium is substantially 1:1.

19. The method of any of claims 2 to 15 wherein the contacting step is performed at a temperature of from 25 °C to 100 °C.

## Patentansprüche

1. Verwendung einer Ätzlösung, die für die gleichzeitige Entfernung von Silizium und Silizium-Germanium von einer mikroelektronischen Vorrichtung geeignet ist, Silizium und Silizium-Germanium umfassend, wobei die Verwendung das Ätzen mit einer Ätzrate für Silizium relativ zu Silizium-Germanium von 3:1 bis 1:3 umfasst und wobei die Ätzlösung umfasst:
0,5 bis 90 Gew.-% Wasser;
0,1 bis 20 Gew.-% eines Oxidationsmittels, das aus der Gruppe ausgewählt ist, die aus Wasserstoffperoxid, Periodsäure, Kaliumiodat, Kaliumpermanganat, Ammoniumpersulfat, Ammoniummolybdat, Eisen(III)-nitrat, Salpetersäure, Kaliumnitrat, Ammoniak und Mischungen davon besteht, oder das Harnstoff-Wasserstoffperoxid ist;
eine Pufferzusammensetzung, die eine Aminverbindung und eine polyfunktionelle organische Säure umfasst, wobei die Aminverbindung mindestens ein Alkanolamin enthält;
0,5 bis 59,5 Gew.-% eines mit Wasser mischbaren Lösungsmittels, ausgewählt aus der Gruppe bestehend aus Hexyloxypropylamin, Poly(oxyethylen)diamin, Alkoholen, Sulfoxiden und Mischungen davon oder ausgewählt aus Glykolethern; und
0,01 bis 10 Gew.-% einer Fluorid-Ionenquelle, ausgewählt aus der Gruppe bestehend aus Fluorwasserstoffsäure, Ammoniumfluorid, quartären Ammoniumfluoroboraten, Fluorborsäure, quartären Ammoniumhexafluoraluminaten und einem Fluoridsalz eines aliphatischen primären, sekundären oder tertiären Amins mit der Formel R¹NR²R³R⁴F, worin R¹, R², R³ und R⁴ einzeln H oder eine C₁-C₄-Alkylgruppe darstellen.

2. Verfahren zum gleichzeitigen Ätzen von Silizium und Silizium-Germanium aus einer mikroelektronischen Vorrichtung, Silizium und Silizium-Germanium umfassend, das Verfahren die folgenden Schritte umfassend:
Inkontaktbringen der mikroelektronischen Vorrichtung, die Silizium und Silizium-Germanium umfasst, mit einer Ätzlösung; und
Spülen der mikroelektronischen Vorrichtung, nachdem das Silizium und Silizium-Germanium zumindest teilweise entfernt wurden, wobei die Ätzrate für Silizium relativ zu Silizium-Germanium von 3:1 bis 1:3 beträgt,
wobei die Ätzlösung umfasst:
0,5 bis 90 Gew.-% Wasser;
0,1 bis 20 Gew.-% eines Oxidationsmittels, das aus der Gruppe ausgewählt ist, die aus Wasserstoffperoxid, Periodsäure, Kaliumiodat, Kaliumpermanganat, Ammoniumpersulfat, Ammoniummolybdat, Eisen(III)-nitrat, Salpetersäure, Kaliumnitrat, Ammoniak und Mischungen davon besteht, oder das Harnstoff-Wasserstoffperoxid ist;
eine Pufferzusammensetzung, die eine Aminverbindung und eine polyfunktionelle organische Säure umfasst, wobei die Aminverbindung mindestens ein Alkanolamin enthält;
0,5 bis 59,5 Gew.-% eines mit Wasser mischbaren Lösungsmittels, ausgewählt aus der Gruppe bestehend aus Hexyloxypropylamin, Poly(oxyethylen)diamin, Alkoholen, Sulfoxiden und Mischungen davon oder aus Glykolethern; und
0,01 bis 10 Gew.-% einer Fluorid-Ionenquelle, ausgewählt aus der Gruppe bestehend aus Fluorwasserstoffsäure, Ammoniumfluorid, quartären Ammoniumfluoroboraten, Fluorborsäure, quartären Ammoniumhexafluoraluminaten und einem Fluoridsalz eines aliphatischen primären, sekundären oder tertiären Amins mit der Formel R¹NR²R³R⁴F, worin R¹, R², R³ und R⁴ einzeln H oder eine C₁-C₄-Alkylgruppe darstellen.

3. Die Verwendung nach Anspruch 1 oder das Verfahren nach Anspruch 2, wobei die Pufferzusammensetzung zusätzlich ein Ammoniumsalz enthält.

4. Die Verwendung oder das Verfahren nach einem der vorhergehenden Ansprüche, wobei das Oxidationsmittel Wasserstoffperoxid ist.

5. Die Verwendung oder das Verfahren nach einem der vorhergehenden Ansprüche, wobei die Aminverbindung eine Alkanolaminverbindung ist, ausgewählt aus der Gruppe bestehend aus N-Methylethanolamin, Monoethanolamin, Diethanolamin, Triethanolamin, Triisopropanolamin, 2-(2-Aminoethylamino)ethanol, 2-(2-Aminoethoxy)ethanol, Triethanolamin, N-Ethylethanolamin, N,N-Dimethylethanolamin, N,N-Diethylethanolamin, N-Methyldiethanolamin, N-Ethyldiethanolamin, Cyclohexylamindiethanol, Diisopropanolamin, Cyclohexylamindiethanol und Mischungen davon.

6. Die Verwendung oder das Verfahren nach einem der vorhergehenden Ansprüche, wobei Alkanolamin Amino(ethoxy)ethanol ist.

7. Die Verwendung oder das Verfahren nach einem der vorhergehenden Ansprüche, wobei das mit Wasser mischbare Lösungsmittel ausgewählt ist aus der Gruppe bestehend aus Ethylenglykol, Propylenglykol, 1,4-Butandiol, Tripropylenglykolmethylether, Propylenglykolpropylether, Diethylenglykol-n-butylether, Hexyloxypropylamin, Poly(oxyethylen)diamin, Dimethylsulfoxid, Tetrahydrofurfurylalkohol, Glycerin und Butyldiglycerin.

8. Die Verwendung oder das Verfahren nach einem der Ansprüche 1 bis 6, wobei das mit Wasser mischbare Lösungsmittel ausgewählt ist aus der Liste bestehend aus Ethylenglykolmonomethylether, Ethylenglykolmonoethylether, Ethylenglykolmonobutylether, Ethylenglykoldimethylether, Ethylenglykoldiethylether, Diethylenglykolmonomethylether, Diethylenglykolmonoethylether, Diethylenglykolmonopropylether, Diethylenglykolmonoisopropylether, Diethylenglykolmonobutylether, Diethylenglykolmonoisobutylether, Diethylenglykolmonobenzylether, Diethylenglykoldimethylether, Diethylenglykoldiethylether, Triethylenglykolmonomethylether, Triethylenglykoldimethylether, Polyethylenglykolmonomethylether, Diethylenglykolmethylethylether, Triethylenglykolmethylethylether, Ethylenglykolmonomethyletheracetat, Ethylenglykolmonoethyletheracetat, Propylenglykolmethyletheracetat, Propylenglykolmonomethylether, Propylenglykoldimethylether, Propylenglykolmonobutylether, Propylenglykolmonopropylether, Dipropylenglykolmonomethylether (DPM), Dipropylenglykolmonopropylether, Dipropylenglykolmonoisopropylether, Dipropylenmonobutylether, Dipropylenglykoldiisopropylether, Tripropylenglykolmonomethylether, 1-Methoxy-2-butanol, 2-Methoxy-1-butanol, 2-Methoxy-2-methylbutanol, 1,1-Dimethoxyethan und 2-(2-Butoxyethoxy)ethanol.

9. Die Verwendung oder das Verfahren nach einem der Ansprüche 1 bis 6, wobei das mit Wasser mischbare Lösungsmittel ausgewählt ist aus der Liste bestehend aus Ethylenglykoldimethylether, Ethylenglykoldiethylether, Diethylenglykolmonomethylether, Diethylenglykolmonoethylether, Diethylenglykolmonopropylether, Diethylenglykolmonoisopropylether, Diethylenglykolmonobutylether, Diethylenglykolmonoisobutylether, Diethylenglykolmonobenzylether, Diethylenglykoldimethylether, Diethylenglykoldiethylether, Triethylenglykolmonomethylether, Triethylenglykoldimethylether, Polyethylenglykolmonomethylether, Diethylenglykolmethylethylether, Triethylenglykolmethylethylether, Ethylenglykolmonomethyletheracetat, Ethylenglykolmonoethyletheracetat, Propylenglykolmethyletheracetat, Propylenglykoldimethylether, Dipropylenglykolmonomethylether, Dipropylenglykolmonopropylether, Dipropylenglykolmonoisopropylether, Dipropylenmonobutylether, Dipropylenglykoldiisopropylether, Tripropylenglykolmonomethylether und 2-(2-Butoxyethoxy)ethanol.

10. Die Verwendung oder das Verfahren nach einem der Ansprüche 1 bis 6, wobei das mit Wasser mischbare Lösungsmittel Diethylenglykolmonobutylether ist.

11. Die Verwendung oder das Verfahren nach einem der Ansprüche 1 bis 6, wobei das mit Wasser mischbare Lösungsmittel Butyldiglycerin ist.

12. Die Verwendung oder das Verfahren nach einem der vorhergehenden Ansprüche, wobei die polyfunktionelle organische Säure eine polyprotische Säure mit mindestens drei Carbonsäuregruppen ist.

13. Die Verwendung oder das Verfahren nach einem der vorhergehenden Ansprüche, wobei die polyfunktionelle Säure ausgewählt ist aus der Gruppe bestehend aus Zitronensäure, 2-Methylpropan-1,2,3-tricarbonsäure, Benzol-1,2,3-tricarbonsäure, Propan-1,2,3-tricarbonsäure, 1,cis-2,3-Propentricarbonsäure, Butan-1,2,3,4-tetracarbonsäure, Cyclopentan-1,2,3,4-tetracarbonsäure, Benzol-1,2,4,5-tetracarbonsäure, Benzolpentacarbonsäure und Benzolhexacarbonsäure sowie deren Mischungen.

14. Die Verwendung oder das Verfahren nach einem der vorhergehenden Ansprüche, wobei der Puffer ein Ammoniumsalz umfasst, das aus der Gruppe ausgewählt ist, die aus Ammoniumchlorid, Ammoniumsulfat, Ammoniumnitrat, Ammoniumcarbonat, Ammoniumhypochlorit, Ammoniumchlorat, Ammoniumpermanganat, Ammoniumacetat, zweibasisches Ammoniumphosphat, Diammoniumcitrat, Triammoniumcitrat, Ammoniumsulfamat, Ammoniumoxalat, Ammoniumformiat, Ammoniumtartrat, Ammoniumbitartrat und Ammoniumglykolat.

15. Die Verwendung oder das Verfahren nach Anspruch 14, wobei der Puffer Triammoniumcitrat umfasst.

16. Das Verfahren nach einem der Ansprüche 2 bis 15 ferner den Schritt des Trocknens der mikroelektronischen Vorrichtung umfassend.

17. Das Verfahren nach einem der Ansprüche 2 bis 15, wobei die Ätzrate für Silizium im Verhältnis zu Silizium-Germanium zwischen 2:1 und 1:2 liegt.

18. Das Verfahren nach einem der Ansprüche 2 bis 15, wobei die Ätzrate für Silizium im Verhältnis zu Silizium-Germanium im Wesentlichen 1:1 beträgt.

19. Verfahren nach einem der Ansprüche 2 bis 15, wobei der Schritt des Inkontaktbringens bei einer Temperatur von 25 °C bis 100 °C durchgeführt wird.

## Revendications

1. Utilisation d'une solution d'attaque appropriée pour l'élimination simultanée de silicium et de silicium-germanium d'un dispositif microélectronique comprenant du silicium et du silicium-germanium,
dans laquelle l'utilisation comprend l'attaque avec un taux d'attaque pour silicium relativement à silicium-germanium de 3 : 1 à 1 : 3, et où la solution d'attaque comprend :
0,5 % à 90 % en poids d'eau ;
0,1 % à 20 % en poids d'un oxydant, qui est sélectionné parmi le groupe constitué de : peroxyde d'hydrogène, acide périodique, iodate de potassium, permanganate de potassium, persulfate d'ammonium, molybdate d'ammonium, nitrate ferrique, acide nitrique, nitrate de potassium, ammoniac, et mélanges de ceux-ci ou qui est urée-peroxyde d'hydrogène ;
une composition tampon comprenant un composé amine et un acide organique polyfonctionnel, dans laquelle le composé amine inclut au moins une alcanolamine ;
0,5 % à 59,5 % en poids d'un solvant miscible à l'eau, sélectionné parmi le groupe constitué de : hexyloxypropylamine, poly(oxyéthylène)diamine, alcools, sulfoxydes, et mélanges de ceux-ci, ou sélectionné parmi des éthers de glycol ; et
0,01 à 10 % en poids d'une source d'ions fluorure, sélectionnée parmi le groupe constitué de : acide hydrofluorique, fluorure d'ammonium, fluoroborates d'ammonium quaternaire, acide fluoroborique, hexafluoroaluminates d'ammonium quaternaire et un sel de fluorure d'une amine primaire, secondaire, ou tertiaire, aliphatique ayant la formule R¹NR²R³R⁴F, dans laquelle R¹, R², R3, et R⁴ représentent individuellement H ou un groupe alkyle en C₁-C₄.

2. Procédé pour l'attaque simultanée de silicium et de silicium-germanium d'un dispositif microélectronique comprenant du silicium et du silicium-germanium, le procédé comprenant les étapes de :
mise en contact du dispositif microélectronique, comprenant du silicium et du silicium-germanium, avec une solution d'attaque ; et
rinçage du dispositif microélectronique après que le silicium et le silicium-germanium sont au moins partiellement éliminés, dans lequel le taux d'attaque pour silicium relativement à silicium-germanium est de 3 : 1 à 1,3,
dans lequel la solution d'attaque comprend :
0,5 % à 90 % en poids d'eau ;
0,1 % à 20 % en poids d'un oxydant, qui est sélectionné parmi le groupe constitué de : peroxyde d'hydrogène, acide périodique, iodate de potassium, permanganate de potassium, persulfate d'ammonium, molybdate d'ammonium, nitrate ferrique, acide nitrique, nitrate de potassium, ammoniac, et mélanges de ceux-ci ou qui est urée-peroxyde d'hydrogène ;
une composition tampon comprenant un composé amine et un acide organique polyfonctionnel, dans lequel le composé amine inclut au moins une alcanolamine ;
0,5 % à 59,5 % en poids d'un solvant miscible à l'eau, sélectionné parmi le groupe constitué de : hexyloxypropylamine, poly(oxyéthylène)diamine, alcools, sulfoxydes, et mélanges de ceux-ci, ou parmi des éthers de glycol ; et
0,01 à 10 % en poids d'une source d'ions fluorure, sélectionnée parmi le groupe constitué de : acide hydrofluorique, fluorure d'ammonium, fluoroborates d'ammonium quaternaire, acide fluoroborique, hexafluoroaluminates d'ammonium quaternaire et un sel de fluorure d'une amine primaire, secondaire, ou tertiaire, aliphatique ayant la formule R¹NR²R³R⁴F, dans laquelle R¹, R², R3, et R⁴ représentent individuellement H ou un groupe alkyle en C₁-C₄.

3. Utilisation de la revendication 1 ou procédé de la revendication 2, dans laquelle ou lequel la composition tampon comprend de plus un sel d'ammonium.

4. Utilisation ou procédé de quelconques des revendications précédentes, dans laquelle ou lequel l'oxydant est peroxyde d'hydrogène.

5. Utilisation ou procédé de quelconques des revendications précédentes, dans laquelle ou lequel le composé amine est un composé alcanolamine sélectionné parmi le groupe constitué de : N-méthyléthanolamine, monoéthanolamine, diéthanolamine, triéthanolamine, triisopropanolamine, 2-(2-aminoéthylamino)éthanol, 2-(2-aminoéthoxy)éthanol, triéthanolamine, N-éthyléthanolamine, N,N-diméthyléthanolamine, N,N-diéthyléthanolamine, N-méthyldiéthanolamine, N-éthyldiéthanolamine, cyclohexylaminediéthanol, diisopropanolamine, cyclohexylaminediéthanol, et mélanges de ceux-ci.

6. Utilisation ou procédé de quelconques des revendications précédentes, dans laquelle ou lequel l'alcanolamine est amino(éthoxy)éthanol.

7. Utilisation ou procédé de quelconques des revendications précédentes, dans laquelle ou lequel le solvant miscible à l'eau est sélectionné parmi le groupe constitué de : éthylène glycol, propylène glycol, 1,4-butanediol, éther méthylique de tripropylène glycol, éther propylique de propylène glycol, éther n-butylique de diéthylène glycol, hexyloxypropylamine, poly(oxyéthylène)diamine, diméthylsulfoxyde, alcool tétrahydrofurfurylique, glycérol, et diglycérol butylique.

8. Utilisation ou procédé de quelconques des revendications 1 à 6, dans laquelle ou lequel le solvant miscible à l'eau est sélectionné parmi la liste constituée de : éther monométhylique d'éthylène glycol, éther monoéthylique d'éthylène glycol, éther monobutylique d'éthylène glycol, éther diméthylique d'éthylène glycol, éther diéthylique d'éthylène glycol, éther monométhylique de diéthylène glycol, éther monoéthylique de diéthylène glycol, éther monopropylique de diéthylène glycol, éther monoisopropylique de diéthylène glycol, éther monobutylique de diéthylène glycol, éther monoisobutylique de diéthylène glycol, éther monobenzylique de diéthylène glycol, éther diméthylique de diéthylène glycol, éther diéthylique de diéthylène glycol, éther monométhylique de triéthylène glycol, éther diméthylique de triéthylène glycol, éther monométhylique de polyéthylène glycol, éther méthyléthylique de diéthylène glycol, éther méthyléthylique de triéthylène glycol, acétate d'éther monométhylique d'éthylène glycol, acétate d'éther monoéthylique d'éthylène glycol, acétate d'éther méthylique de propylène glycol, éther monométhylique de propylène glycol, éther diméthylique de propylène glycol, éther monobutylique de propylène glycol, éther monopropylique de propylène glycol, éther monométhylique de dipropylène glycol (DPM), éther monopropylique de dipropylène glycol, éther monoisopropylique de dipropylène glycol, éther monobutylique de dipropylène, éther diisopropylique de dipropylène glycol, éther monométhylique de tripropylène glycol, 1-méthoxy-2-butanol, 2-méthoxy-1-butanol, 2-méthoxy-2-méthylbutanol, 1,1-diméthoxyéthane et 2-(2-butoxyéthoxy)éthanol.

9. Utilisation ou procédé de quelconques des revendications 1 à 6, dans laquelle ou lequel le solvant miscible à l'eau est sélectionné parmi la liste constituée de : éther diméthylique d'éthylène glycol, éther diéthylique d'éthylène glycol, éther monométhylique de diéthylène glycol, éther monoéthylique de diéthylène glycol, éther monopropylique de diéthylène glycol, éther monoisopropylique de diéthylène glycol, éther monobutylique de diéthylène glycol, éther monoisobutylique de diéthylène glycol, éther monobenzylique de diéthylène glycol, éther diméthylique de diéthylène glycol, éther diéthylique de diéthylène glycol, éther monométhylique de triéthylène glycol, éther diméthylique de triéthylène glycol, éther monométhylique de polyéthylène glycol, éther méthyléthylique de diéthylène glycol, éther méthyléthylique de triéthylène glycol, acétate d'éther monométhylique d'éthylène glycol, acétate d'éther monoéthylique d'éthylène glycol, acétate d'éther méthylique de propylène glycol, éther diméthylique de propylène glycol, éther monométhylique de dipropylène glycol, éther monopropylique de dipropylène glycol, éther monoisopropylique de dipropylène glycol, éther monobutylique de dipropylène, éther diisopropylique de dipropylène glycol, éther monométhylique de tripropylène glycol, et 2-(2-butoxyéthoxy)éthanol.

10. Utilisation ou procédé de quelconques des revendications 1 à 6, dans laquelle ou lequel le solvant miscible à l'eau est éther monobutylique de diéthylène glycol.

11. Utilisation ou procédé de quelconques des revendications 1 à 6, dans laquelle ou lequel le solvant miscible à l'eau est diglycérol butylique.

12. Utilisation ou procédé de quelconques des revendications précédentes, dans laquelle ou lequel l'acide organique polyfonctionnel est un acide polyprotique ayant au moins trois groupes acide carboxylique.

13. Utilisation ou procédé de quelconques des revendications précédentes, dans laquelle ou lequel l'acide polyfonctionnel est sélectionné parmi le groupe constitué de : acide citrique, acide 2-méthylpropane-1,2,3-triscarboxylique, acide benzène-1,2,3-tricarboxylique, acide propane-1,2,3-tricarboxylique, acide 1,cis-2,3-propènetricarboxylique, acide butane-1,2,3,4-tétracarboxylique, acide cyclopentanetétra-1,2,3,4-carboxylique, acide benzène-1,2,4,5-tétracarboxylique, acide benzènepentacarboxylique, et acide benzènehexacarboxylique, et mélanges de ceux-ci.

14. Utilisation ou procédé de quelconques des revendications précédentes, dans laquelle ou lequel le tampon comprend un sel d'ammonium sélectionné parmi le groupe constitué de : chlorure d'ammonium, sulfate d'ammonium, nitrate d'ammonium, carbonate d'ammonium, hypochlorite d'ammonium, chlorate d'ammonium, permanganate d'ammonium, acétate d'ammonium, phosphate d'ammonium dibasique, citrate de diammonium, citrate de triammonium, sulfamate d'ammonium, oxalate d'ammonium, formate d'ammonium, tartrate d'ammonium, bitartrate d'ammonium et glycolate d'ammonium.

15. Utilisation ou procédé de la revendication 14, dans laquelle ou lequel le tampon comprend du citrate de triammonium.

16. Procédé de quelconques des revendications 2 à 15, comprenant en outre l'étape de séchage du dispositif microélectronique.

17. Procédé de quelconques des revendications 2 à 15, dans lequel le taux d'attaque pour silicium relativement à silicium-germanium est de 2 : 1 à 1 : 2.

18. Procédé de quelconques des revendications 2 à 15, dans lequel le taux d'attaque pour silicium relativement à silicium-germanium est sensiblement 1 : 1.

19. Procédé de quelconques des revendications 2 à 15, dans lequel l'étape de mise en contact est réalisée à une température de 25 °C à 100 °C.
